# EUROPÄISCHE PATENTSCHRIFT

(11) **EP 1 008 858 B1**
(45) Veröffentlichungstag und Bekanntmachung des Hinweises auf die Patenterteilung: **14.07.2004**
(21) Anmeldenummer: 99122485.8
(22) Anmeldetag: 11.11.1999
(51) Int. Cl.: G01R 31/30, G11C 29/00, G01R 31/316

(54) **Schaltungsanordnung mit temperaturabhängiger Halbleiterbauelement-Test- und Reparaturlogik**
Circuit with logic circuit for temperature dependant semi-conductor element test and repair
Circuit avec circuit logique de test et reparation d'un élément à sèmi-conducteurs dépendant de la température

(30) Priorität: 13.11.1998 DE 19852430
(43) Veröffentlichungstag der Anmeldung: 14.06.2000
(73) Patentinhaber: Infineon Technologies AG, 81669 München (DE)
(72) Erfinder: McConnell, Roderick, Dr., 81541 München (DE); Richter, Detlev, 81825 München (DE)
(74) Vertreter: Müller - Hoffmann & Partner

(56) Entgegenhaltungen:
- EP-A- 0 715 176
- US-A- 5 406 212

## Beschreibung

Die vorliegende Erfindung betrifft eine Schaltungsanordnung mit temperaturabhängiger Halbleiterbauelement-Test- und Reparaturlogik, bei der in einem Halbleiterchip des Halbleiterbauelements wenigstens ein Temperatursensor vorgesehen ist.

Halbleiterbauelemente, wie beispielsweise Halbleiterspeicher, werden vor ihrer Auslieferung an Kunden daraufhin überprüft, ob sie bei bestimmten Temperaturen noch einwandfrei arbeiten. Bisher wird hierzu ein Halbleiterspeicher in einen Tester gebracht, in welchem die auf den Halbleiterspeicher einwirkende Temperatur extern eingestellt werden kann. Ist diese Temperatur, beispielsweise 87°C, erreicht, so wird in dem Tester der Halbleiterspeicher auf seine Funktionsfähigkeit überprüft, wozu ihm bestimmte Testsignale zugeführt werden.

Ist die Temperatur im Tester nicht regelbar, so sind die Testergebnisse oft nicht befriedigend, da bestimmte Eigenschaften eines Halbleiterspeichers stark von der Temperatur abhängen. Es ist also durchaus möglich, daß bei der Testtemperatur, also beispielsweise bei den bereits erwähnten 87°C, nicht alle möglichen Fehler des Halbleiterspeichers zuverlässig ermittelt werden können.

Aus IEEE TRANSACTIONS ON VERY LARGE SCALE INTEGRATION (VLSI) SYSTEMS, Band 5, Nr. 3, September 1997, Seiten 270-276, sind CMOS-Sensoren bekannt, die aus MOS-Schaltungen bestehen und zur Temperaturerfassung in integrierte Schaltkreise eingebaut werden können. Auf das Testen von Speichern wird in dieser Druckschrift aber nicht eingegangen.

Schließlich ist aus DE 198 28 192 A1 (GR 98 P 1943 DE) eine Schaltungsanordnung zur Steuerung der Chiptemperatur eines zu testenden Halbleiterspeichers bekannt, bei der im Chip des Halbleiterspeichers wenigstens ein Temperatursensor vorgesehen ist. In dem Chip sind der Halbleiterspeicher und der Temperatursensor mit einer Temperatursteuereinheit verbunden. Damit ist es möglich, die Chiptemperatur des Halbleiterspeichers auf verschiedene Werte einzustellen, so daß auch bei starker Temperaturabhängigkeit von bestimmten Eigenschaften des Halbleiterspeichers eine gute Testabdeckung erzielt werden kann.

Mit dieser bekannten Schaltungsanordnung ist es aber nicht möglich, einen gerade einem Test unterworfenen Halbleiterspeicher sofort zu reparieren. Vielmehr kann hier eine Reparatur des Halbleiterspeichers erst nach Abschluß des Testes vorgenommen werden, was beispielsweise durch die Verwendung üblicher Laserfuses geschehen kann, welche entsprechend beim Test ermittelten Fehlstellen des Halbleiterspeichers geschossen werden.

Eine andere Möglichkeit besteht darin, einen Halbleiterspeicher bei jeder Inbetriebnahme des Halbleiterspeichers mit einer auf dessen Chip vorgesehener Test- und Reparaturlogik zu testen und zu reparieren. Das heißt, die Reparatur wird hier direkt auf dem Chip des Halbleiterspeichers ausgeführt. Ein derartiges Vorgehen kann aber unbefriedigende Ergebnisse liefern, da in diesem Fall der Halbleiterspeicher nicht bei den jeweils erforderlichen Betriebstemperaturen getestet wird.

Es ist daher Aufgabe der vorliegenden Erfindung, eine Schaltungsanordnung mit temperaturabhängiger Bauelement-Test- und Reparaturlogik zu schaffen, mit der der Chip des Halbleiterbauelements nach einem Test bei verschiedenen Temperaturen ohne weiteres repariert werden kann.

Diese Aufgabe wird bei einer Schaltungsanordnung der eingangs genannten Art erfindungsgemäß dadurch gelöst, daß in dem Halbleiterchip das Halbleiterbauelement mit dem Temperatursensor und eine Selbsttest- und Reparaturlogik miteinander verbunden sind.

Die Schaltungsanordnung enthält also in dem Halbleiterchip zusätzlich zu dem Halbleiterbauelement und einem Temperatursensor noch eine Selbsttest- und Reparaturlogik, so daß nicht nur, wie in der Schaltungsanordnung gemäß DE 198 28 192 A1 die Betriebstemperatur für den Testvorgang eingestellt werden kann, sondern auch bei jeder Inbetriebnahme oder zu anderen geeigneten Zeitpunkten ohne weiteres unmittelbar im Anschluß an den Testvorgang eine Reparatur vorgenommen werden kann. Die Reparatur, also der Ersatz beispielsweise fehlerhafter Speicherstellen bei einem Halbleiterspeicher als Halbleiterbauelement, kann entweder permanent statisch durch Schießen entsprechender Laserfuses oder temporär durch Zuschalten redundanter Speicherelemente in gesonderten Registern erfolgen.

Die Erfindung ermöglicht so eine vorteilhafte Verbindung einer Reparatur mittels einer Selbsttest- und Reparaturlogik mit einem temperaturabhängigen Test mittels eines im Halbleiterchip des Halbleiterbauelements enthaltenen Temperatursensors.

In einem konkreten Beispiel enthält die erfindungsgemäße Schaltungsanordnung als Halbleiterbauelement einen Halbleiterspeicher. Im Halbleiterchip dieses Halbleiterspeichers sind zusätzlich noch ein Temperatursensor, beispielsweise ein temperaturabhängiger Oszillator, und eine Selbsttest- und Reparaturlogik (BIST) enthalten. Soll nun mittels dieser Schaltungsanordnung eine "Selbstreparatur" des Halbleiterspeichers ausgeführt werden, so wird zunächst mit Hilfe des Temperatursensors dessen Temperatur überprüft. Ist die dabei ermittelte Temperatur für den Test nicht geeignet, so wird vom BIST ein Temperaturänderungsbetrieb eingeschaltet. Sobald dann von dem Temperatursensor das Erreichen der geeigneten Temperatur gemeldet wird, beginnt der Selbsttest. Sollte während dieses Selbsttestes die Temperatur erneut von der geeigneten Temperatur abweichen, so wird dieser Selbsttest unterbrochen, und der Temperaturänderungsbetrieb wird kurzfristig erneut eingeschaltet. Auf diese Weise kann zuverlässig bei der geeigneten Temperatur der Halbleiterspeicher getestet werden.

Nach Auffinden aller defekten Speicherzellen wird sodann im BIST eine geeignete Reparaturkonfiguration ausgerechnet, um anschließend die Reparatur, beispielsweise durch Setzen eines Registers für redundante Speicherzellen oder durch Programmieren elektrisch setzbarer Fuseblöcke, vorzunehmen. Sobald die Reparatur des Halbleiterspeichers abgeschlossen ist, wird dieser als fehlerfrei gemeldet. Sollte eine solche Reparatur nicht möglich sein, so kann dies ebenfalls als Information angezeigt werden.

Nachfolgend wird die Erfindung anhand der Zeichnungen näher erläutert. Es zeigen:
- Fig. 1: ein Blockschaltbild eines ersten Ausführungsbeispiels der erfindungsgemäßen Schaltungsanordnung und
- Fig. 2: ein etwas ausführlicheres Blockschaltbild eines zweiten Ausführungsbeispiels der erfindungsgemäßen Schaltungsanordnung.

In den Figuren werden sich einander entsprechende Teile jeweils mit den gleichen Bezugszeichen versehen.

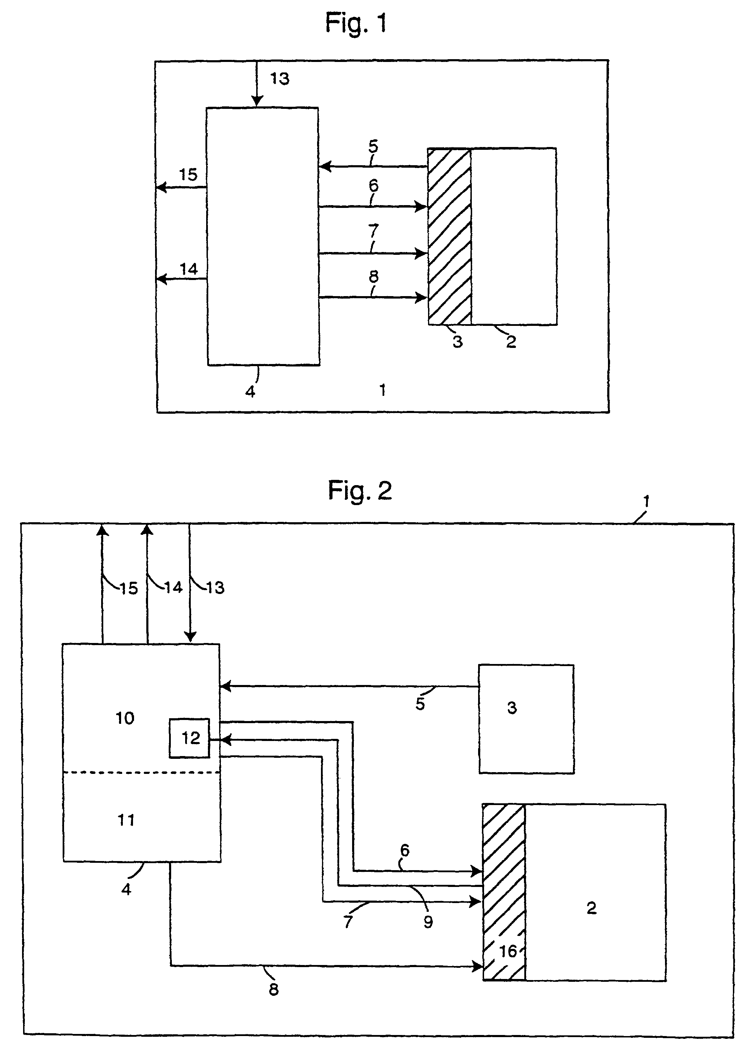

In Fig. 1 sind in einem Halbleiterchip 1 als Beispiel eines Halbleiterbauelements ein Halbleiterspeicher 2, ein in dessen Nähe vorgesehener bzw. unmittelbar angrenzender Temperatursensor 3 und eine Selbsttest- und Reparaturlogik 4 integriert. Der Temperatursensor 3, der aus der oben erwähnten bekannten CMOS-Schaltung bestehen kann, mißt die Temperatur des Halbleiterchips 1 im Bereich des Halbleiterspeichers 2 und übermittelt diese Temperatur an die Selbsttest- und Reparaturlogik 4, wie dies durch einen Pfeil 5 veranschaulicht ist. Liegt die durch den Temperatursensor 3 festgestellte Temperatur des Halbleiterchips 1 im Bereich der Testtemperatur, so leitet die Selbsttest- und Reparaturlogik 4 einen Testmodus ein, wie dies durch einen Pfeil 6 angedeutet ist. Liegt die durch den Temperatursensor 3 festgestellte Temperatur des Halbleiterchips 1 außerhalb des Bereiches der Testtemperatur, so wird von der Selbsttest- und Reparaturlogik 4 entweder die Temperatur des Halbleiterchips 1 hochgefahren oder abgesenkt (vgl. Pfeil 7).

Mittels der Selbsttest- und Reparaturlogik 4 können so ohne weiteres verschiedene Bereiche für die Testtemperatur eingestellt werden, so daß der Halbleiterspeicher 2 bei verschiedenen Testtemperaturen auf seine Zuverlässigkeit überprüft werden kann. Es ist damit also eine große Testabdeckung zu erzielen, so daß auch Eigenschaften eines Halbleiterspeichers, die stark temperaturabhängig sind, zuverlässig überprüft werden können.

Wird nun bei dem von der Selbsttest- und Reparaturlogik 4 vorgenommenen Test des Halbleiterspeichers 2 ein Fehler festgestellt, welcher beispielsweise im Auffinden einer oder mehrerer defekter Speicherzellen bestehen kann, so rechnet die Selbsttest- und Reparaturlogik 4 eine Reparaturkonfiguration aus und nimmt anschließend die Reparatur vor, indem in üblicher Weise beispielsweise Fuses eines redundanten Speicherzellenfeldes im Halbleiterspeicher 2 geschossen werden. Diese Reparatur ist durch einen Pfeil 8 veranschaulicht.

Nach Abschluß der Reparatur wird der nunmehr fehlerfreie Halbleiterspeicher 2 freigegeben (Pfeil 14) oder als nicht reparierbar (Pfeil 15) nach außen gemeldet.

Der oben erläuterte Test- und Reparaturvorgang an dem Halbleiterspeicher 2 kann über ein in den Halbleiterchip 1 eingespeistes BIST-Startsignal (vgl. Pfeil 13) jederzeit ausgelöst werden, so daß es ohne weiteres möglich ist, bei jeder Inbetriebnahme des Halbleiterspeichers 2 oder zu anderen geeigneten Zeitpunkten diesen Test- und Reparaturvorgang auszuführen. Wie bereits erwähnt wurde, kann anstelle einer statischen Reparatur gegebenenfalls auch eine temporäre Reparatur mittels gesonderten elektrischen Speicherelementen in der Form von Registern vorgenommen werden.

Fig. 2 zeigt ein weiteres Ausführungsbeispiel der erfindungsgemäßen Schaltungsanordnung, bei dem der Temperatursensor 3 in der Nähe des Halbleiterspeichers 2 vorgesehen ist. Hier ist auch eine selbstverständlich beim Ausführungsbeispiel der Fig. 1 ebenfalls vorhandene Schnittstelle 16 des Halbleiterspeichers 2 gesondert dargestellt. Der Temperatursensor kann beispielsweise Temperaturbereiche bis 25°C, 25°C bis 75°C, 75°C bis 125°C und über 125°C haben. Diese vier Temperaturbereiche können dann digital beispielsweise mit "00", "01", "10" bzw. "11" dargestellt werden. An die Selbsttest- und Reparaturlogik 4 aus einer Selbsttestlogik 10 und einer Reparaturlogik 11 werden entsprechende Digitalwerte über einen 2-Bit-Bus (vgl. Pfeil 5) geliefert. Die Einleitung eines Testmodus erfolgt sodann über einen Bus (vgl. Pfeil 6), sofern die gemeldete Temperatur in dem von der Selbsttestlogik 10 vorgegebenen Bereich liegt. Trifft dies nicht zu, so wird die Chiptemperatur entsprechend geändert (vgl. Pfeil 7).

Die während eines Tests im Halbleiterspeicher 2 ermittelten Daten werden über einen Bus (vgl. Pfeil 9) an die Selbsttestlogik 10 gespeist und dort in einem Vergleicher 12 überprüft. Werden Fehler festgestellt, so werden entsprechende redundante Speicherzellen im Halbleiterspeicher 2 gesetzt (vgl. Pfeil 8). Dabei ist es möglich, die redundanten Speicherzellen durch Setzen von entsprechenden Registern einzublenden. Eine andere Möglichkeit besteht darin, daß die Selbsttest- und Reparaturlogik 4 redundante Sepicherzellen durch Programmierung nicht-flüchtiger Speicherelemente (beispielsweise EPROM, Flash-Speicher, elektrische Fuses) setzt.

Die erfindungsgemäße Schaltungsanordnung ist in vorteilhafter Weise bei Halbleiterspeichern, wie beispielsweise DRAMs usw. anwendbar. Sie kann aber auch bei sonstigen Halbleiterbauelementen eingesetzt werden, die temperaturabhängigen Tests zu unterwerfen sind und zu denen redundante Bauelemente bestehen.

## Patentansprüche

1. Schaltungsanordnung mit temperaturabhängiger Halbleiterbauelement-Test- und Reparaturlogik (4), bei der in einem Halbleiterchip (1) eines Halbleiterbauelements (2) wenigstens ein Temperatursensor (3) vorgesehen ist,
**dadurch gekennzeichnet,**
**daß** in dem Halbleiterchip (1) das Halbleiterbauelement (2) mit dem Temperatursensor (3) und eine Selbsttest- und Reparaturlogik (4) miteinander verbunden sind.

2. Schaltungsanordnung nach Anspruch 1,
**dadurch gekennzeichnet,**
**daß** die Selbsttest- und Reparaturlogik (4) eine Temperatursteuereinheit enthält.

3. Schaltungsanordnung nach Anspruch 1 oder 2,
**dadurch gekennzeichnet,**
**daß** die Temperatursteuereinheit in einen Temperaturänderungsbetrieb schaltet, wenn der Temperatursensor (3) einen außerhalb des Testtemperaturbereiches liegenden Temperaturwert für die Temperatur des Halbleiterchips (1) ermittelt.

4. Schaltungsanordnung nach einem der Ansprüche 1 bis 3,
**dadurch gekennzeichnet,**
**daß** die Selbsttest- und Reparaturlogik (4) einen Mikroprozessor als Selbsttestlogik (10) und eine Reparaturlogik (11) umfaßt.

5. Schaltungsanordnung nach Anspruch 4,
**dadurch gekennzeichnet,**
**daß** in der Selbsttestlogik (10) ein Vergleicher (12) enthalten ist.

6. Schaltungsanordnung nach einem der Ansprüche 1 bis 5,
**dadurch gekennzeichnet,**
**daß** die Selbsttest- und Reparaturlogik (4) redundante Speicherzellen im Halbleiterspeicher (2) setzt (Pfeil 8).

7. Schaltungsanordnung nach einem der Ansprüche 1 bis 6,
**dadurch gekennzeichnet,**
**daß** die Selbsttest- und Reparaturlogik (4) redundante Speicherzellen durch Setzen von Registern einblendet.

8. Schaltungsanordnung nach einem der Ansprüche 1 bis 6,
**dadurch gekennzeichnet,**
**daß** die Selbsttest- und Reparaturlogik redundante Speicherzellen durch Programmierung nicht-flüchtiger Speicherelemente setzt.

## Revendications

1. Montage à circuit (4) logique de test et de réparation d'un composant à semi-conducteur dépendant de la température, dans lequel il est prévu, dans une puce (1) à semi-conducteur d'un composant (2) à semi-conducteur, au moins un capteur (3) de température,
**caractérisé**
**en ce que** dans la puce (1) à semi-conducteur, le composant (2) à semi-conducteur ayant le capteur (3) de température et un circuit (4) logique d'autotest et de réparation sont reliés entre eux.

2. Montage suivant la revendication 1,
**caractérisé**
**en ce que** le circuit (4) logique d'autotest et de réparation comporte une unité de réglage de la température.

3. Montage suivant la revendication 1 ou 2,
**caractérisé**
**en ce que** l'unité de réglage de la température passe à un fonctionnement de modification de la température lorsque le capteur (3) de température détermine, pour la température de la puce (1 ) à semi-conducteur, une valeur de température se trouvant à l'extérieur de la plage de température de test.

4. Montage suivant l'une des revendications 1 à 3,
**caractérisé**
**en ce que** le circuit (4) logique d'autotest et de réparation comprend un micro-processeur comme circuit (10) logique d'autotest et un circuit (11) logique de réparation.

5. Montage suivant la revendication 4,
**caractérisé**
**en ce qu'**un comparateur (12) est contenu dans le circuit (10) logique d'autotest.

6. Montage suivant l'une des revendications 1 à 5,
**caractérisé**
**en ce que** le circuit (4) logique d'autotest et de réparation positionne des cellules de mémoires redondantes dans la mémoire (2) à semi-conducteur (flèche 8).

7. Montage suivant l'une des revendications 1 à 6,
**caractérisé**
**en ce que** le circuit (4) logique d'autotest et de réparation, incruste des cellules de mémoires redondantes par mise en place de registres.

8. Montage suivant l'une des revendications 1 à 6, **caractérisé en ce que** le circuit logique d'autotest et de réparation met des cellules de mémoires redondantes par programmation d'éléments de mémoire non volatiles.

## Claims

1. Circuit arrangement having a temperature-dependent semiconductor-component test and repair logic unit (4), in which a semiconductor chip (1) for a semiconductor component (2) contains at least one temperature sensor (3),
**characterized**
**in that** the semiconductor component (2) with the temperature sensor (3) and a self-test and repair logic unit (4) are connected to one another in the semiconductor chip (1).

2. Circuit arrangement according to Claim 1,
**characterized**
**in that** the self-test and repair logic unit (4) contains a temperature control unit.

3. Circuit arrangement according to Claim 1 or 2,
**characterized**
**in that** the temperature control unit switches to a temperature change mode if the temperature sensor (3) ascertains a temperature value for the temperature of the semiconductor chip (1) which is outside the test temperature range.

4. Circuit arrangement according to one of Claims 1 to 3,
**characterized**
**in that** the self-test and repair logic unit (4) comprises a microprocessor as a self-test logic unit (10) and a repair logic unit (11).

5. Circuit arrangement according to Claim 4,
**characterized**
**in that** the self-test logic unit (10) contains a comparator (12).

6. Circuit arrangement according to one of Claims 1 to 5,
**characterized**
**in that** the self-test and repair logic unit (4) sets (arrow 8) redundant memory cells in the semiconductor memory (2).

7. Circuit arrangement according to one of Claims 1 to 6,
**characterized**
**in that** the self-test and repair logic unit (4) unmasks redundant memory cells by setting registers.

8. Circuit arrangement according to one of Claims 1 to 6,
**characterized**
**in that** the self-test and repair logic unit sets redundant memory cells by programming non-volatile memory elements.
